# FASCICULE DE BREVET EUROPEEN

(11) **EP 3 146 350 B1**
(45) Date de publication et mention de la délivrance du brevet: **28.02.2018**
(21) Numéro de dépôt: 15718537.2
(22) Date de dépôt: 02.04.2015
(51) Int. Cl.: G01R 31/12, G01R 31/02

(54) **APPAREILLAGE SEC A HAUTE TENSION EQUIPE D'UN DISPOSITIF DE CONTROLE EN CONTINU**
MIT EINER VORRICHTUNG MIT KONTINUIERLICHER ÜBERWACHUNG AUSGESTATTETE HOCHSPANNUNGS-TROCKENVORRICHTUNG
HIGH-VOLTAGE DRY APPARATUS PROVIDED WITH A CONTINUOUS MONITORING DEVICE

(30) Priorité: 20.05.2014 FR 1454487
(43) Date de publication de la demande: 29.03.2017
(73) Titulaire: Nexans, 92400 Courbevoie (FR)
(72) Inventeur: MIREBEAU, Pierre, F-91140 Villebon sur Yvette (FR)
(74) Mandataire: Lenne, Laurence
(86) Numéro de dépôt international: PCT/FR2015/050854
(87) Numéro de publication internationale: WO 2015/177419

(56) Documents cités:
- EP-A1- 1 633 028
- FR-A1- 2 712 115
- US-A- 5 892 430
- US-A1- 2006 076 946
- Peter C J M Van ET AL: "ON-LINE PARTIAL DISCHARGE DETECTION OF MV CABLES WITH DEFECT LOCALISATION (PDOL) BASED ON TWO TIME SYNCHRONISED SENSORS", , 6 juin 2005 (2005-06-06), pages 1-5, XP055123588, Turin Extrait de l'Internet: URL:http://www.cired.net/publications/cire d2005/papers/cired2005_0456.pdf [extrait le 2014-06-16]

## Description

L'invention concerne un appareillage sec à haute tension équipé d'un dispositif de contrôle en continu.

S'il est connu de contrôler un appareillage à haute tension contenant de l'huile par une surveillance du niveau de cette huile et un appareillage à haute tension contenant un gaz diélectrique par une surveillance de la pression de ce gaz, le contrôle d'un appareillage sec peut aujourd'hui être effectué par une mesure des décharges partielles de préférence en permanence, dont le principe est par exemple décrit dans la publication « 2009 IEEE Electrical Insulation Conference, Montreal, QC, Canada, 31 May-3 June 2009 » dans l'article « On Line Partial Discharge Diagnosis of Power Cables » en page 210.

Pour ce faire, il peut être utilisé le dispositif appelé « Smart Sensor Grid » fabriqué par la société TECHI MP.

Ce dispositif dont l'agencement électronique est décrit dans la demande de brevet WO 2007/144789 par exemple, est installé sur le conducteur de terre et comporte une bobine détectrice disposée autour de ce conducteur.

Un tel agencement présente les problèmes techniques suivants.

Disposé sur le conducteur de terre, à l'extérieur de toute protection, cet agencement est soumis aux perturbations extérieures, telles que par exemple les lignes aériennes, la circulation automobile ou la présence de moteurs électriques.

La sensibilité d'un tel agencement est relativement mauvaise et son amélioration, en utilisant une bobine en ferrite, serait coûteuse. Or, dans le cas de terminaisons ou de jonctions à haute tension, la sensibilité doit être, selon les normes, de l'ordre de 5 pico-Coulombs.

Un tel dispositif nécessite par ailleurs une alimentation électrique spécifique pour son utilisation en permanence.

L'invention résout ces problèmes en équipant un appareillage sec à haute tension d'un dispositif de contrôle en permanence, interne à l'appareillage.

L'invention propose donc un appareillage sec à haute tension comportant un câble à haute tension pourvu d'une couche semi-conductrice recouverte d'un écran métallique, cet écran étant supprimé pour découvrir cette couche semi-conductrice sur une longueur, ce câble étant connecté à un élément d'équipement pourvu d'une enveloppe connectée mécaniquement audit écran, caractérisé en ce qu'un agencement électronique de contrôle est contenu dans ladite enveloppe, cet agencement électronique étant électriquement connecté à un agencement d'alimentation électrique entourant ladite couche semi-conductrice, et à l'écran métallique dudit câble de part et d'autre de ladite longueur de la couche semi-conductrice dénudée.

L'agencement d'alimentation électrique peut entourer directement ladite couche semi-conductrice dénudée ou l'entourer à un autre endroit avec interposition d'une partie conductrice.

Grâce à l'invention, l'enveloppe de l'équipement forme une cage de Faraday et élimine les perturbations extérieures.

Sans nécessité de ferrite, on réalise in situ un couplage capacitif de sensibilité excellente.

L'agencement électronique est autoalimenté au moyen du câble haute tension.

Selon un mode de réalisation préféré, ledit agencement électronique de contrôle est un agencement de mesure des décharges partielles.

Mais il peut être également un agencement de mesure de courant dans les écrans métalliques ou de courant de terre, afin de vérifier le fonctionnement d'une jonction et/ou localiser un claquage électrique.

De préférence, ledit agencement électronique est également connecté à un dispositif de traitement externe à ladite enveloppe.

De préférence, ledit agencement d'alimentation électrique est constitué d'un capteur de courant entourant ladite couche semi-conductrice dénudée.

Le document de brevet US 5 892 430 décrit un capteur de ce type.

Avantageusement, ledit capteur comporte un anneau de conducteur hélicoïdal entourant ladite couche semi-conductrice.

Ledit élément d'équipement peut être une extrémité et ladite enveloppe être un cylindre métallique prolongeant le boîtier métallique de protection de l'extrémité.

Ledit élément d'équipement peut être une jonction et ladite enveloppe être un boîtier métallique de protection de la jonction.

L'invention est décrite ci-après plus en détail à l'aide de figures représentant
La figure 1 une vue partielle en coupe longitudinale d'un appareillage constitué d'une extrémité conforme à l'invention.
La figure 2 est une vue en coupe longitudinale partielle d'un appareillage constitué d'une jonction conforme à l'invention.
La figure 3 est une vue de détail de la figure 2.

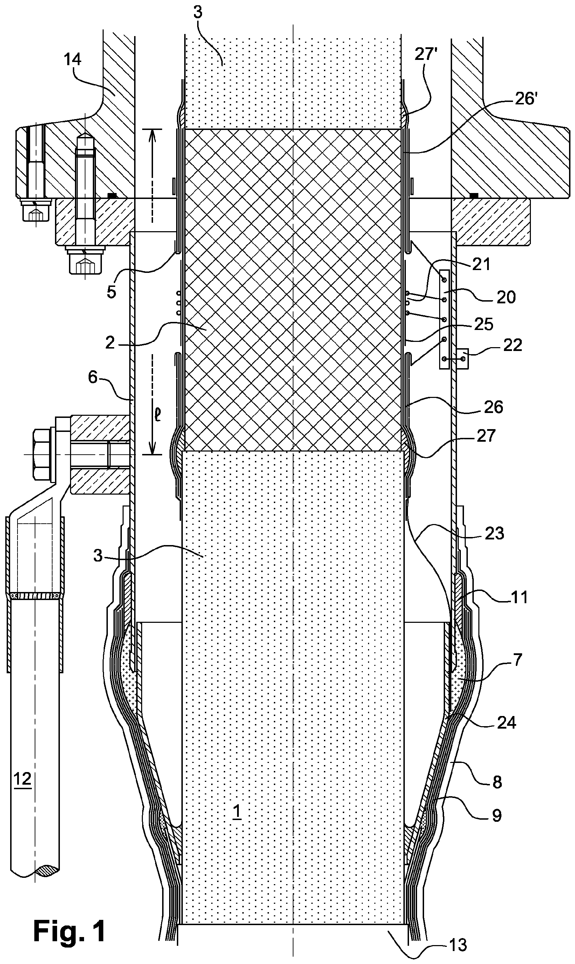

Selon la figure 1, un appareillage sec à haute tension comporte un câble à haute tension 1 pourvu d'une couche semi-conductrice 2 recouverte d'un écran métallique 3, cet écran étant supprimé pour découvrir cette couche semi-conductrice sur une longueur l. Ce câble 1 est connecté à un élément d'équipement, ici une extrémité non visible contenue dans un boîtier métallique de protection 14 pourvu d'une enveloppe externe métallique 6 formée d'un cylindre métallique prolongeant le boîtier métallique de protection 14 de l'extrémité et connecté mécaniquement à l'écran 3 du câble 1, du côté opposé à l'extrémité.

Plus précisément, le câble d'énergie haute ou très haute tension comporte, de l'intérieur vers l'extérieur, autour d'un conducteur, une couche isolante, une couche de semi-conducteur 2, un écran métallique 3 et une gaine externe isolante 13.

Pour sa liaison avec l'extrémité, la gaine externe 13 est retirée sur une certaine longueur, un joint de soudure 7 est réalisé entre l'écran métallique 3 du câble et l'enveloppe 6 de l'élément d'équipement relié à un câble de terre 12 et un élément de liaison est disposé entre le câble 1 et l'extrémité, venant par l'une de ses extrémités en contact avec la gaine externe du câble 13 et par son autre extrémité en contact avec la surface externe du cylindre 6.

Cet élément de liaison comporte un tronçon de gaine thermo-rétractable 8 ainsi appliquée longitudinalement entre la gaine externe 13 du câble 1 et la surface externe du cylindre 6, et radialement entre ce tronçon de gaine thermorétractable 8 et la gaine externe 13 du câble, la surface externe du cylindre 6 et la soudure 7, est classiquement disposée une couche isolante 9.

La solidarisation du tronçon de gaine thermo-rétractable 8 au cylindre 6 de l'extrémité est effectuée par soudage d'un élément métallique 11 à protubérances d'ancrage puis application du tronçon de gaine thermo-rétractable 8.

A titre d'exemple, un tel agencement de connexion d'un câble haute tension avec un élément d'équipement est décrit dans le brevet EP 1 633 028.

Selon l'invention, un agencement électronique de mesure des décharges partielles 20 est contenu dans le cylindre 6, cet agencement électronique étant connecté:
- électriquement à un agencement d'alimentation électrique 21 entourant la couche semi-conductrice 2 dénudée du câble,
- électriquement à l'écran métallique 3 du câble de part et d'autre de la longueur l de la couche semi-conductrice dénudée et
- à un dispositif de traitement externe 22, extérieur au cylindre métallique 6, au moyen de fibres optiques ou d'une liaison radio.

L'agencement d'alimentation électrique 21 est constitué d'un capteur de courant entourant la couche semi-conductrice 2 du câble au niveau de la longueur l et comporte de préférence un conducteur hélicoïdal enroulé en plusieurs spires autour de la couche conductrice 2. Une bande isolante de protection 25 est intercalée entre le capteur 21 et la couche semi-conductrice 2 du câble, cette bande pouvant avoir une largeur d'environ 50 mm.

A titre d'exemple, un tel capteur de courant flexible est commercialisé par la société Chauvin Arnoux sous la dénomination «AmpFLEX».

L'agencement électronique 20 est associé à un transformateur du courant capté par le capteur 21 en courant d'alimentation de cet agencement électronique.

Du côté de la longueur l de couche semi-conductrice dénudée opposé à l'extrémité, l'agencement électronique 20 est électriquement connecté à l'écran métallique 3 du câble par l'intermédiaire d'un conducteur 23 connectée au moyen du joint de soudure 7 à un cylindre conique 24 conducteur de transition entre le cylindre 6 et l'écran 3 du câble et soudé par son extrémité distale à l'écran 3 du câble.

A son extrémité tournée vers la couche semi-conductrice 2 dénudée du câble, le conducteur 23 est solidarisé par un joint de mastic 27 à une bande conductrice 26 entourant une partie de l'écran 3 et une partie de la couche semi-conductrice 2 du câble.

En fait, cette bande conductrice 26 est constituée d'un tricot métallique formant écran, enserré entre un ruban semi-conducteur protégeant la couche semi-conductrice 2 et un ruban isolant extérieur.

Du côté de la longueur l de couche semi-conductrice dénudée tourné vers l'extrémité, l'agencement électronique 20 est électriquement connecté à l'écran métallique 3 du câble par une bande conductrice 26' entourant une partie de l'écran 3 et une partie de la couche semi-conductrice 2 du câble, avec un joint de mastic 27'. Comme précédemment, cette bande conductrice 26' est constituée d'un tricot métallique formant écran, enserré entre un ruban semi-conducteur protégeant la couche semi-conductrice 2 et un ruban isolant extérieur.

Le dispositif de traitement externe 22 peut consister en un dispositif de détection et/ou de sauvegarde.

Il peut être un voyant permettant de déterminer à partir de l'extérieur de l'appareillage si les décharges partielles dépassent un seuil admissible ou une prise permettant la transmission des données de mesures de décharges partielles.

Selon le mode de réalisation décrit ci-dessus, l'élément d'équipement est une extrémité et ladite enveloppe est un cylindre métallique 6 prolongeant le boîtier métallique de protection 14 de l'extrém ité.

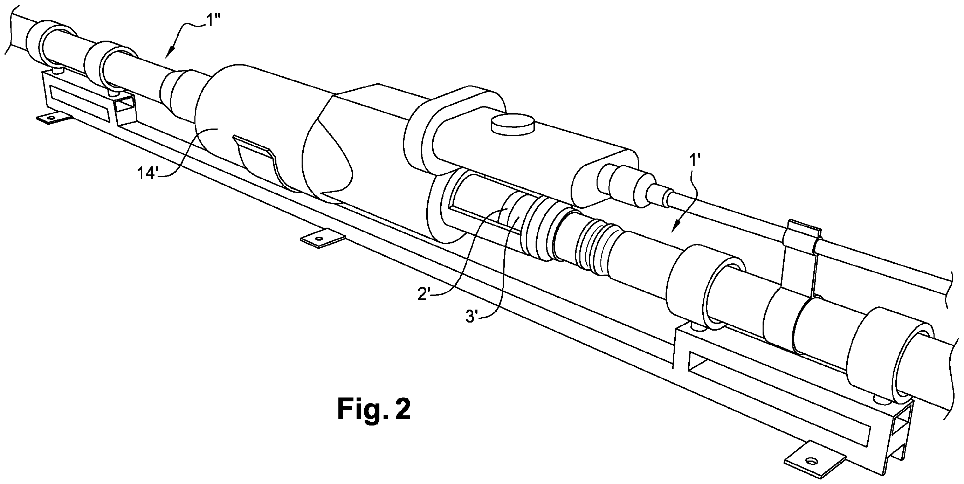

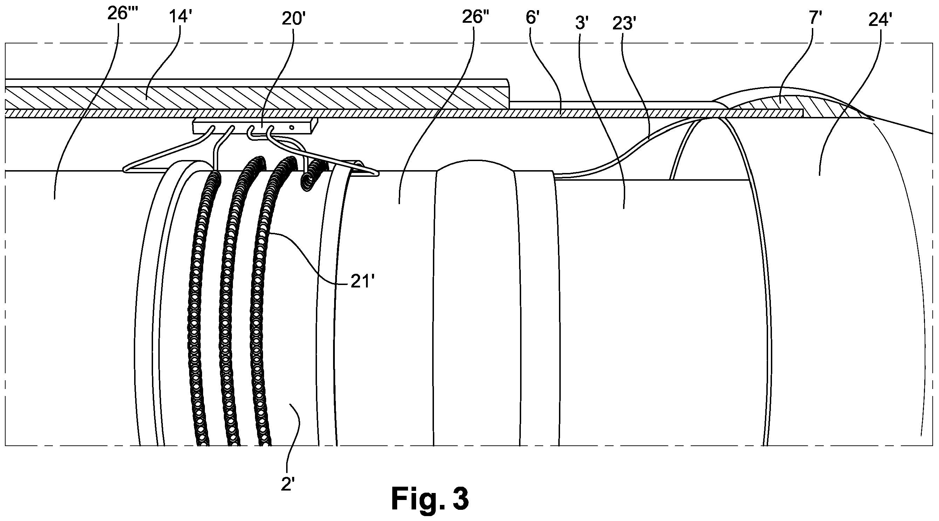

L'invention peut être également appliquée à une jonction de câbles telle que représentée sur les figures 2 et 3.

Cette jonction à haute tension comporte deux câbles 1', 1" pourvus d'une couche semi-conductrice 2' recouverte d'un écran métallique 3', un câble étant ici visible sur la figure 2 par une coupe.

L'écran 3' est supprimé pour découvrir la couche semi-conductrice 2'. Le câble 1' est connecté à un élément d'équipement, ici une jonction contenue dans un boîtier métallique de protection 14' pourvu d'une enveloppe externe métallique formée d'un cylindre métallique prolongeant le boîtier métallique de protection de la jonction et connecté mécaniquement à l'écran du câble 1', du côté opposé à la jonction.

Plus précisément, le câble d'énergie haute ou très haute tension comporte, de l'intérieur vers l'extérieur, autour d'un conducteur, une couche isolante, une couche de semi-conducteur 2', un écran métallique 3' et une gaine externe isolante non visible.

Comme visible en détail sur la figure 3, pour sa liaison avec la jonction, la gaine externe est retirée sur une certaine longueur, un joint de soudure 7' est réalisé entre l'écran métallique 3' du câble et l'enveloppe 6' de l'élément d'équipement relié à un câble de terre et un élément de liaison est disposé entre le câble 1' et la jonction, venant par l'une de ses extrémités en contact avec la gaine externe du câble et par son autre extrémité en contact avec la surface externe du cylindre 6'.

A titre d'exemple, un tel agencement de connexion d'un câble haute tension avec un élément d'équipement est décrit dans le brevet EP 1 633 028.

Selon l'invention, un agencement électronique de mesure des décharges partielles 20' est contenu dans le cylindre 6', cet agencement électronique étant connecté :
- électriquement à un agencement d'alimentation électrique 21' entourant la couche semi-conductrice 2' dénudée du câble,
- électriquement à l'écran métallique du câble de part et d'autre de la couche semi-conductrice dénudée et
- à un dispositif de traitement externe, non représenté, extérieur au cylindre métallique 6', au moyen de fibres optiques ou d'une liaison radio.

L'agencement d'alimentation électrique 21' est constitué d'un capteur de courant entourant la couche semi-conductrice 2' du câble et comporte de préférence un conducteur hélicoïdal enroulé en plusieurs spires autour de la couche conductrice 2'. Une bande isolante de protection peut être intercalé entre le capteur 21' et la couche semi-conductrice 2' du câble, cette bande pouvant avoir une largeur d'environ 50 mm.

Comme précédemment, à titre d'exemple, un tel capteur de courant flexible est commercialisé par la société Chauvin Arnoux sous la dénomination «AmpFLEX».

L'agencement électronique 20' est associé à un transformateur du courant capté par le capteur 21' en courant d'alimentation de cet agencement électronique.

Du côté de la longueur de couche semi-conductrice dénudée opposé à la jonction, l'agencement électronique 20' est électriquement connecté à l'écran métallique du câble par l'intermédiaire d'une bande conductrice 26", d'un conducteur 23' connectée au moyen du joint de soudure 7' à un cylindre conique 24' conducteur de transition entre le cylindre 6' et l'écran 3' du câble et soudé par son extrémité distale à l'écran du câble.

A son extrémité tournée vers la couche semi-conductrice 2' dénudée du câble, le conducteur 23' est solidarisé par un joint de mastic au tronçon d'écran reconstitué formé par la bande conductrice 26".

En fait, cette bande conductrice 26" est constituée d'un tricot métallique formant écran, enserré entre un ruban semi-conducteur protégeant la couche semi-conductrice 2' et un ruban isolant extérieur.

Du côté de la couche semi-conductrice dénudée tourné vers la jonction, l'agencement électronique 20' est électriquement connecté à l'écran métallique du câble par une bande conductrice 26"' entourant une partie de l'écran et une partie de la couche semi-conductrice 2' du câble, avec un joint de mastic. Comme précédemment, cette bande conductrice 26"' est constituée d'un tricot métallique formant écran, enserré entre un ruban semi-conducteur protégeant la couche semi-conductrice 2' et un ruban isolant extérieur.

## Revendications

1. Appareillage sec à haute tension comportant un câble à haute tension pourvu d'une couche semi-conductrice (2, 2') recouverte d'un écran métallique (3, 3'), cet écran (3, 3') étant supprimé pour découvrir cette couche semi-conductrice (2, 2') sur une longueur, ce câble étant connecté à un élément d'équipement pourvu d'une enveloppe externe (6, 6') connectée mécaniquement audit écran, **caractérisé en ce qu'**un agencement électronique de contrôle (20, 20') est contenu dans ladite enveloppe (6, 6'), cet agencement électronique (20, 20') étant électriquement connecté à un agencement d'alimentation électrique (21, 21') entourant ladite couche semi-conductrice (2, 2') et à l'écran métallique (3) dudit câble de part et d'autre de ladite longueur de la couche semi-conductrice dénudée.

2. Appareillage selon la revendication 1, **caractérisé en ce que** ledit agencement électronique de contrôle (20, 20') est un dispositif de mesure des décharges partielles.

3. Appareillage selon la revendication 1 ou 2, **caractérisé en ce que** ledit agencement électronique (20, 20') est également connecté à un dispositif de communication (22) externe à ladite enveloppe externe (6, 6').

4. Appareillage selon l'une des revendications précédentes, **caractérisé en ce que** ledit agencement d'alimentation électrique (21, 21') est constitué d'un capteur de courant entourant ladite couche semi-conductrice dénudée (2, 2').

5. Appareillage selon la revendication précédente, **caractérisé en ce que** ledit capteur comporte un conducteur hélicoïdal entourant ladite couche semi-conductrice (2, 2').

6. Appareillage selon l'une des revendications précédentes, **caractérisé en ce que** ledit élément d'équipement est une extrémité et ladite enveloppe est un cylindre métallique (6) prolongeant le boîtier métallique de protection (14) de l'extrémité.

7. Appareillage selon l'une des revendications 1 à 5, **caractérisé en ce que** ledit élément d'équipement est une jonction et ladite enveloppe (6') est un boîtier métallique de protection.

## Patentansprüche

1. Hochspannungs-Trockenvorrichtung, umfassend ein Hochspannungskabel, das mit einer Halbleiterschicht (2, 2') versehen ist, die mit einer Metallabschirmung (3, 3') gedeckt ist, wobei die Abschirmung (3, 3') über eine Länge abgenommen wird, um die Halbleiterschicht (2, 2') freizulegen, wobei das Kabel an eine Ausrüstung mit einer mit der Abschirmung mechanisch verbundenen Außenhülle (6, 6') angeschlossen ist, **dadurch gekennzeichnet, dass** eine elektronische Steuerungsanordnung (20, 20') in der Hülle (6, 6') enthalten ist, wobei die Anordnung (20, 20') eine Stromversorgungsanordnung (21, 21), die die Halbleiterschicht (2, 2') umgibt, und an die Metallabschirmung (3) des Kabels beiderseits der Länge der freigelegten Halbleiterschicht elektronisch angeschlossen ist.

2. Vorrichtung nach Anspruch 1, **dadurch gekennzeichnet, dass** die elektronische Steuerungsanordnung (20, 20') eine Vorrichtung zum Messen von Teilentladungen ist.

3. Vorrichtung nach Anspruch 1 oder 2, **dadurch gekennzeichnet, dass** die Anordnung (20, 20') ebenfalls an eine Kommunikationsvorrichtung (22) angeschlossen ist, die außerhalb der Außenhülle (6, 6') angeordnet ist.

4. Vorrichtung nach einem der vorstehenden Ansprüche, **dadurch gekennzeichnet, dass** Stromversorgungsanordnung (21, 21') aus einem Stromsensor besteht, der die freigelegte Halbleiterschicht (2, 2') umgibt.

5. Vorrichtung nach dem vorstehenden Anspruch, **dadurch gekennzeichnet, dass** der Sensor einen wendelförmigen Leiter umfasst, der die Halbleiterschicht (2, 2') umgibt.

6. Vorrichtung nach einem der vorstehenden Ansprüche, **dadurch gekennzeichnet, dass** die Ausrüstung ein Ende ist und die Hülle ein metallischer Zylinder (6) ist, der das metallische Schutzgehäuse (14) des Endes verlängert.

7. Vorrichtung nach einem der Ansprüche 1 - 5, **dadurch gekennzeichnet, dass** die Ausrüstung eine Verbindungsstelle ist und die Hülle (6') ein metallisches Schutzgehäuse ist.

## Claims

1. A high-voltage dry apparatus including a high-voltage cable provided with a semi-conductive layer (2, 2') covered by a metal screen (3, 3'), this screen (3, 3') being eliminated to expose this semi-conductive layer (2, 2') over a length, this cable being connected to an equipment element provided with an outer enclosure (6, 6') mechanically connected to said screen, **characterized in that** an electronic control arrangement (20, 20') is contained in said enclosure (6, 6'), this electronic arrangement (20, 20') being electrically connected to a power supply arrangement (21, 21') surrounding said semi-conductive layer (2, 2') and to the metal screen (3) of said cable on either side of said length of the stripped semi-conductive layer.

2. The apparatus according to claim 1, **characterized in that** said electronic control arrangement (20, 20') is a device for measuring partial discharges.

3. The apparatus according to claim 1 or 2, **characterized in that** said electronic arrangement (20, 20') is also connected to a communication device (22) outside said outer enclosure (6, 6').

4. The apparatus according to one of the preceding claims, **characterized in that** said power supply arrangement (21, 21') is made up of a current sensor surrounding said stripped semi-conductive layer (2, 2').

5. The apparatus according to the preceding claim, **characterized in that** said sensor includes a helical conductor surrounding said semi-conductive layer (2, 2').

6. The apparatus according to one of the preceding claims, **characterized in that** said equipment element is an end and said enclosure is a metal cylinder (6) extending the metal protective housing (14) from the end.

7. The apparatus according to one of claims 1 to 5, **characterized in that** said equipment element is a junction and said enclosure (6') is a metal protective housing.
